(19) **Europäisches Patentamt**
**European Patent Office**
**Office européen des brevets**

(11) Publication number: **0 116 774 B1**

# EUROPEAN PATENT SPECIFICATION

(45) Date of publication of patent specification: **24.07.91**   (51) Int. Cl.⁵: **G11C 11/24**

(21) Application number: **83307761.3**

(22) Date of filing: **20.12.83**

(54) Semiconductor memory device with a refresh mechanism.

(30) Priority: **27.12.82 JP 226705/83**

(43) Date of publication of application:
**29.08.84 Bulletin 84/35**

(45) Publication of the grant of the patent:
**24.07.91 Bulletin 91/30**

(84) Designated Contracting States:
**DE FR GB IT**

(56) References cited:
**US-A- 3 533 089**
**US-A- 3 737 879**
**US-A- 3 852 800**
**US-A- 3 858 184**
**US-A- 4 292 676**

**Triebel,Walter A. Handbook of semiconductor and bubble memories, Prentice-Hall, Inc, Englewood Cliffs, N.J. 1982**

(73) Proprietor: **KABUSHIKI KAISHA TOSHIBA**
**72, Horikawa-cho Saiwai-ku**
**Kawasaki-shi Kanagawa-ken 210(JP)**

(72) Inventor: **Sakui, Koji c/o Patent Division**
**TOKYO SHIBAURA DENKI K.K. 72 Horikawa-cho**
**Sawai-ku Kawasaki-shi Kanagawa-ken(JP)**
Inventor: **Horiguchi, Fumio c/o Patent Division**
**TOKYO SHIBAURA DENKI K.K. 72 Horikawa-cho**
**Sawai-ku Kawasaki-shi Kanagawa-ken(JP)**

(74) Representative: **Shindler, Nigel et al**
**BATCHELLOR, KIRK & CO. 2 Pear Tree Court**
**Farringdon Road**
**London EC1R 0DS(GB)**

## Description

The present invention relates to a semiconductor memory device with a refresh mechanism such as a memory device consisting of dynamic memory cells, and more particularly to a semiconductor memory device with an improved refresh mechanism.

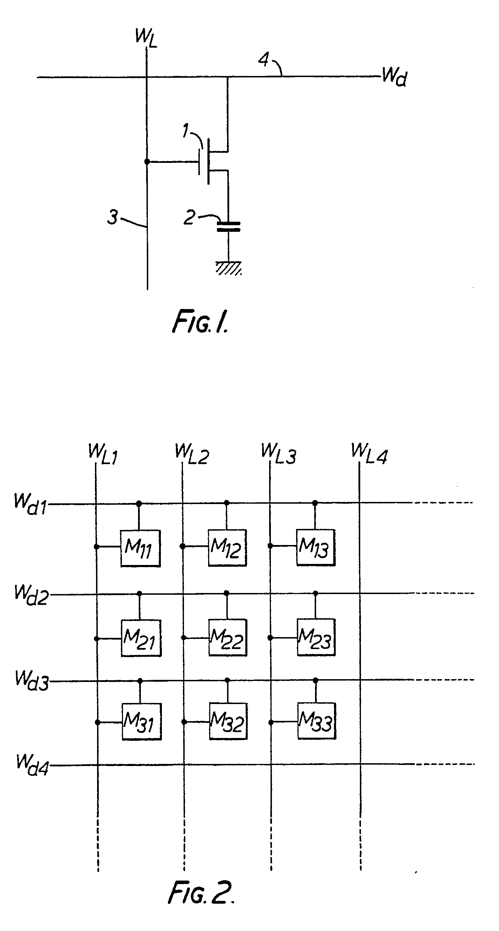

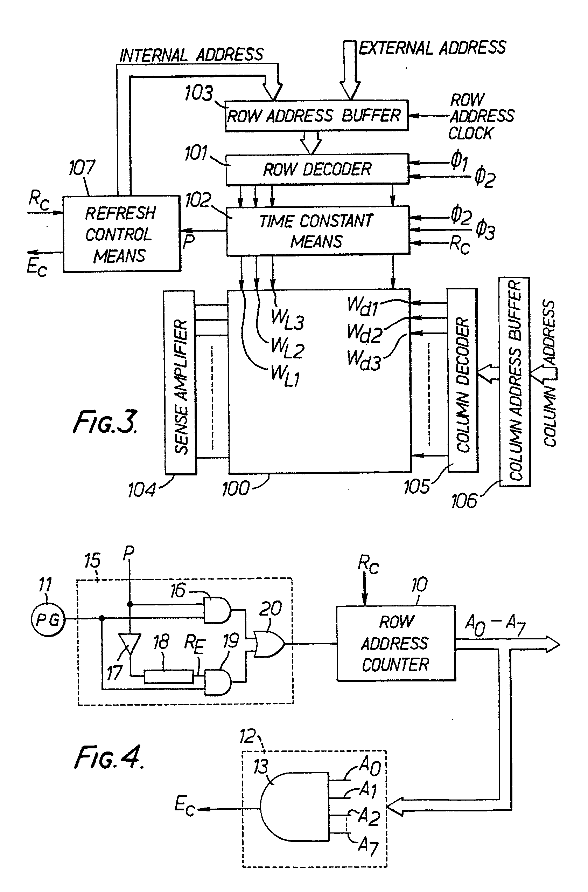

Various types of semiconductor memory with a rewrite facility have come into use of late, the commonest being the memory cell illustrated in Figure 1, consisting of one MOS transistor 1 and one MOS capacitor 2. In this memory cell, the gate of the MOS transistor 1 is connected to the word line, while the drain is connected to the digit line, and the data for storage is stored in the MOS capacitor 2 in the form of an electric charge. When a memory device, e.g. a dynamic random access memory (RAM), is formed from memory cells of this kind, these memory cells M are connected at the intersections of a plurality of word lines WL and a plurality of bit lines Wd arranged in matrix form, as shown in Figure 2.

In a dynamic RAM constructed in this way, data is stored as described above in the form of an electric charge, but some time after writing in the data the charge stored in the MOS capacitor 2 is lost because of leakage current, etc. If the data is left, after being written into the MOS capacitor 2, until a read-out is required, what has been stored in the MOS capacitor 2 may become corrupted. Also, the charge stored in the MOS capacitor 2 can be increased or decreased by soft errors. 'Soft errors' here means corruption of the data stored in the capacitor of the memory cell or faulty action of the sense amplifier, due to invasion of the diffusion layer of the memory cell or bit line by rays absorbed in minute amounts by the package and semi-conductor substrate.

In the case of a dynamic RAM, therefore, provision has been made hitherto for a refresh period every 2 msec, during which access is not possible. During this period, the data stored in the MOS capacitor 2 is rewritten for all bits - it is, in short, refreshed. Usually a refresh control circuit is used when this refresh operation takes place, selecting each word line in succession and refreshing the memory cells word line by word line.

However, this kind of conventional memory device involved the following problem. Because the word line selected during the access period were also thereby refreshed, this practice of refreshing all the bits on all the word lines during the refresh period meant that word lines not yet requiring to be refreshed were refreshed twice in succession. These unnecessary refresh operations increased the consumption of electric current, and were also inconvenient in that they made it impossible to shorten the refresh period, during which data could not be accessed.

The present invention seeks to provide a semiconductor memory device whereby word lines selected during the access period and therefore not requiring to be refreshed are not selected during the refresh period, and whereby also the consumption of electric power during the refresh period is reduced and the refresh period itself can be shortened.

Accordingly the invention provides a semiconductor memory device comprising a plurality of memory cells each consisting of one transistor and one capacitor, a plurality of word lines ($W_L$) for addressing said memory cells, a plurality of digit lines (Wd) for reading and/or writing the data of said memory cells, an access control means for accessing said memory cells by selecting said word lines, a refresh clock Rc for starting a refresh period at fixed intervals, a refresh control means for successively selecting said word line connected to each of said memory cells and refreshing said memory cells word line by word line in the refresh period; characterised by

a pulse generator generating pulses at intervals shorter than the time taken to refresh one word line, and a timing means connected to each of the word lines, each of said timing means being so arranged that it is activated whenever the word line connected to it is selected during an access period and being arranged to supply a "refresh not required" signal until a predetermined tire has elapsed, said refresh control means being arranged to detect said "refresh not required" signal and to then select the next word line, and wherein said refresh control means includes;

a row address counter for successively selecting said word lines in accordance with pulse signals from said pulse generator, a first circuit means for detecting the data in said row address counter and emitting a pulse signal indicating the end of said refresh period, and a second circuit means which is so arranged that

(a) when said "refresh not required" signal is supplied from said timing means, the row address counter is incremented by 1 without a refresh signal being issued to the corresponding word line; and

(b) when said "refresh not required" signal is not supplied, the incrementation of the row address counter is delayed, a refresh signal is issued, and the row address counter is incremented after completion of the refresh process for the corresponding word line.

Refresh systems which are intended to save power and reduce refresh time are shown in US-A-3,737,879 and US-A-4,292,676. However, US-A-3,737,879 differs from the device of the present invention in that a refresh period is interposed into the memory access operation whenever any one of the rows has not been accessed or refreshed for a predetermined time period. Thus, rather than preventing the refreshing of a specific row from taking place within a refresh period, that starts at fixed intervals, the refresh circuitry of US-A-3,737,879 triggers the refreshment of the row in question at an unpredictable time.

US-A-4,292,676 makes use of a specific refresh timer for starting refresh periods at fixed intervals but needs a block of auxiliary memory in order to memorise the addresses of the rows which have been recently accessed so that they can be skipped in the next refresh period.

Some embodiments of the invention will now be described by way of example with reference to the accompanying drawings in which:

Figure 1 is a circuit diagram showing the layout of a memory cell:;

Figure 2 is a schematic diagram of the layout of a dynamic RAM using the above-mentioned memory cell:;

Figure 3 is a block diagram showing in schematic form the layout of the main parts of an embodiment of the present invention:;

Figure 4 is a circuit diagram of the refresh control means included in Figure 3:;

Figure 5 is a flow-chart explaining the working of the embodiment shown in Figure 3:;

Figure 6 is a circuit diagram showing the layout of a row decoder and a time constant means shown in Figure 3:;

Figure 7 is a signal waveform chart explaining the working of the circuit shown in Figure 6:;

Figure 8 is a block diagram showing in schematic form the layout of the main parts of another embodiment of the present invention; and

Figure 9 is a circuit diagram of the main parts of a refresh control means included in Figure 8.

Reference will now be made to the drawings, wherein like reference numerals designed identical or corresponding parts throughout the several views.

Figure 3 illustrates a block diagram of the present invention, in which reference numeral 100 designates an array of dynamic memory cells in which a plurality of memory cells M are integrated on a semiconductor substrate and are arranged in matrix form. Each cell consists of one MOS transistor and one MOS capacitor in the same manner as shown in Figure 1. Each of these memory cells M is connected at the intersection of a plurality of word lines WL and a plurality of digit lines Wd.

The word lines WL are connected to a row decoder 101 through a time constant means 102. The row decoder 101 is further connected to a row address buffer 103. A row address is supplied to the row address buffer 103 to select the word lines WL. The row address consists of two kinds of address i.e. an external address and an internal address, and one of these addresses is selectively supplied to the row address buffer 103 by a switching mechanism. A row address clock signal is supplied to the row address buffer 103, and the signals $\phi_1$ and $\phi_2$ are supplied to the row decoder 101. A signal $\phi_2$ is also supplied to the time constant means 102 with signals $\phi_3$ and Rc. The time constant means 102 emits a signal P which indicates that a refresh is not necessary in a refresh period.

A sense amplifier 104 and a column decoder 105 are connected to the digit lines Wd. A column buffer 106 to which a column address is supplied, is connected to the column decoder 105.

Reference numeral 107 designates a refresh control means which controls the supply of the internal address which is used for a refresh of the memory cells in a refresh period. This control is carried out by detecting the signal P. Further, the refresh control means 107 is activated by receiving the signal Rc, and emits a signal Ec when the refresh period is completed.

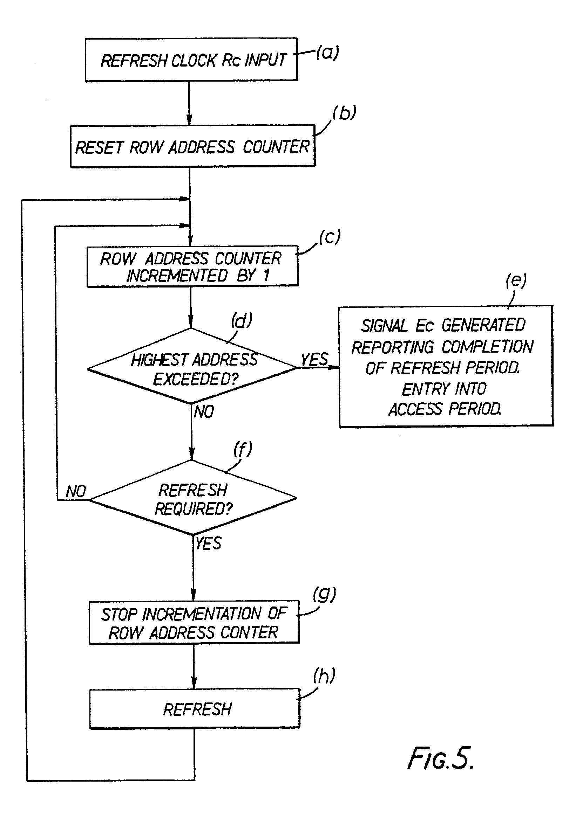

Figure 4 shows a circuit diagram of the refresh control means 107. In this figure, reference numeral 10 designates a row address counter. The counter 10 is reset by the refresh clock Rc and incremented by 1 on receipt of a pulse from a pulse generator 11. As a result, the counter 10 supplies the internal address of, for example 8 bits, according to the count data. The internal address signal is also applied to a first circuit 12 consisting of a parallel circuit of a plurality of AND gates 13. This first circuit 12 detects when the data stored in the address counter 10 exceeds the highest available address, and emits the signal Ec. That is to say, when all bits of the internal address signal are "1", the first circuit 12 emits the signal "1", for example. This signal Ec shows that the refresh period is over, and the access period will be started.

The refresh control means also includes a second circuit 15. This second circuit 15 consists of an AND gate 16, inverter gate 17, a time delay circuit 18, AND gate 19 and OR gate 20. The pulse signal from the pulse generator 11 is supplied to the AND gates 16 and 19, and the signal P is supplied to AND gate 16 and NOT gate 17. As a result, when the signal P is "1", the pulses from the pulse generator 11 are supplied to the row address counter 10 through AND gate l6 and OR gate 20 in order to increment the data in the counter 10 by 1. When the signal P is "0", incrementation of the row address counter 10 is not carried out because AND gate 16 is closed. The delay time of the delay circuit 18 is so predetermined that the incrementation of the address counter 10 is stopped until refreshing of a word line is completed. Thus, when the signal P is "0", that is, when a refresh of its word line is necessary, the signal P is converted to "1" by inverter gate 17, and then delayed by the delay circuit 18. A signal which is delayed at a predetermined time is supplied to AND gate 19 as a signal RE which indicates the completion of the refresh process.

The time delay circuit 18, inverter gate 17, AND gate 19 and OR gate 20 can be eliminated if the signal RE is obtained by another method. For example, the signal RE can be obtained by the signals of a so-called row address clock chain.

The operation of the device constructed as described above is as follows referring to the flowchart shown in Figure 5. First, when the refresh clock Rc is applied to the row address counter 10 -(a), the address counter 10 is reset -(b), and the address counter 10 is incremented by 1-(c). Next, the first circuit 12 checks whether or not the highest available address has been exceeded -(d). If it has been exceeded, the signal Ec, signalling that refresh period has been completed, is generated by the first circuit 12, and the access period is entered -(e) If the highest available address has not been exceeded, a test is performed to establish whether or not the word line corresponding to the address requires to be refreshed -(f). If the signal P is "1", that is, refreshing is not required, the sequence returns to (c), and the address counter 10 is once again incremented by 1. If the signal P is "0", that is refreshing is required, the incrementation of the address counter 10 is stopped -(g), and the word line corresponding to the address is refreshed -(h). After completion of the refresh of this word line, the sequence returns to (c), i.e. the pulse from the pulse generator 11 is supplied to the address counter 10 through AND gate 19 and OR gate 20, the address counter 10 is incremented by 1, and the operation described above is repeated.

The time taken for the sequence (c)-(g) described above is shorter than the time taken to refresh one word line because the pulse generator 11 generates pulses at intervals shorter than the time taken to refresh one word line, and refreshing a word line previously accessed is thus skipped quickly. Thus the time taken to refresh a word line previously accessed in a conventional device is not substantially necessary in the present invention, and thus it is possible to shorten the refresh period.

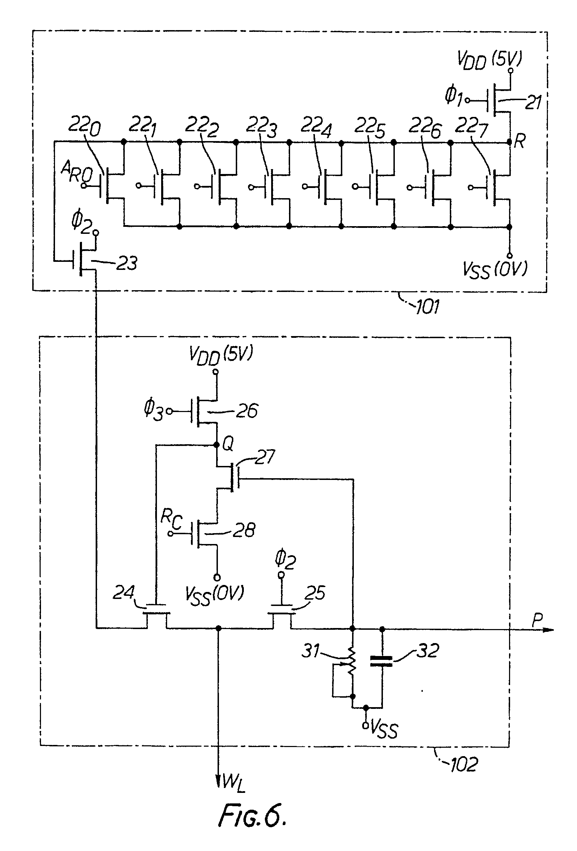

Figure 6 is a circuit diagram showing the row decoder 101 and the time constant means 102 shown in Figure 3. The diagram depicts one word line only, as the layout is the same for all word lines. A MOS transistor 21, MOS transistors $22_0$-$22_7$ connected in parallel and a MOS transistor 23 are connected in series to form a decoder. A source electrode of the transistor 21 is connected to a voltage source $V_{DD}$ (for example, 5 volts), and the pulse signal $\phi_1$ is supplied to a gate electrode of the transistor 21. Drain electrodes of the transistors $22_0$-$22_7$ are connected to a voltage source $V_{SS}$ (for example, 0 volts). The pulse $\phi_2$ is supplied to a source electrode of the transistor 23. If the pulse signal $\phi_1$ is high and address input signals $A_{R0}$-$A_{R7}$ are low, the voltage potential of point R becomes high. This means that this word line is selected by the decoder 101. The output signal of the decoder is supplied to the transistor 23.

The time constant means 102 consists of MOS tranistors 24-28 and a parallel circuit of a variable resistor 31 and a capacitor 32. The source electrode of the transistor 24 is connected to a drain electrode of the transistor 23, and the drain electrode of the transistor 24 is connected to the source electrode of the transistor 25. The gate electrode of the transistor 24 is connected to the connection point of the transistors 26 and 27. The drain electrode of the transistor 25 and the gate electrode of the transistor 27 are connected to a parallel circuit of a resistor 31 and a capacitor 32. The voltage $V_{DD}$ is supplied to the source electrode of the transistor 26, a pulse signal $\phi_2$ is supplied to the gate electrode of the transistor 25 and a pulse signal $\phi_3$ is supplied to the gate electrode of the transistor 26. The transistors 27 and 28 are connected in series, and the refresh clock signal $R_C$ is supplied to a gate electrode of the transistor 28. A word line $W_L$ is connected to the interconnecting point of the transistors 24 and 25.

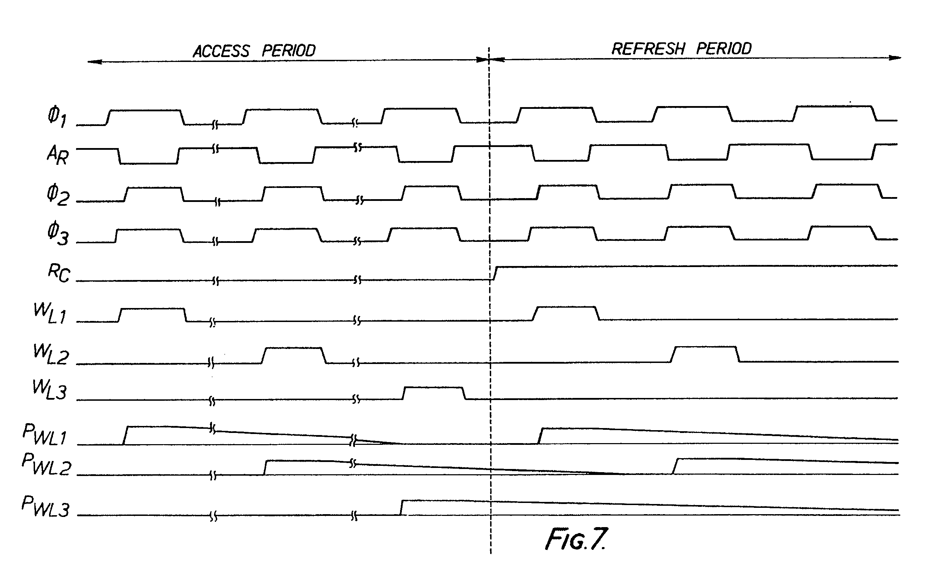

The operation of the circuit described above is as follows, referring to the timing chart shown in Figure 7. During an access cycle, firstly, the point R is precharged by the clock $\phi_1$. Then, address input signals $A_R$ ($A_{R0}$-$A_R$) are supplied. If the address input signals $A_R$ are low and clocks $\phi_2$ and $\phi_3$ are then supplied, transistors 23-26 turn on. As a result, the refreshing of the selected word line is started. Figure 7 shows that three word lines $WL_1$, $WL_2$, and $WL_3$ are selected for refreshing in the access cycle.

At the same time the word line is selected for refreshing, the capacitor 32 is also charged to the 'high' potential, and the capacitor 32 is discharged, via the resistor 31, when the clock $\phi_2$ goes low. Consequently, the potential at point P gradually alters from 'high' to 'low'. The time constant of the discharge is determined by the product CR of the resistance R of the resistor 31 and the capacitance C of the capacitor 32, and can be set to suit requirements such as the maximum permitted refresh intervals, in order to select the resistance value.

Figure 7 shows the potentials $P_{WL1}$, $P_{WL2}$ and

$P_{WL3}$, corresponding to the word lines $WL_1$, $WL_2$ and $WL_3$ respectively.

During the refresh cycle, when the refresh clock $R_C$ goes high, the transistor 28 switches on. If the potential P is still 'high', the transistor 27 is also on and the potential at point Q is taken low. Hence the transistor 24 will stay off even when the clocks $\phi_1$, $\phi_2$, and $\phi_3$ go high, and the word line stays low. The result is, therefore, that there is no refreshing of the word line corresponding to the address. In such a circumstance, the signal P ("1") is supplied to the refresh control means 107, and the incrementation of the row address counter 10 is carried out.

If, however, a fixed time after the charging of the capacitor 32 has elapsed, the potential at point P becomes "low", the transistor 27 switches off and the potential at point Q is taken 'high' when the clock $\phi_3$ goes high. In such a circumstance, the row address counter 10 in the refresh control means 107 is not incremented, and the word line corresponding to the address is refreshed.

Figure 7 shows the case in which the word line $W_{L3}$ is not refreshed because the potential $P_{WL3}$ is still 'high'.

As described above, when the potential at point P is high during the refresh period, that is to say, in the event that the clocks $\phi_1$, $\phi_2$, and $\phi_3$ go high when refreshing is not required in respect of that word line, a pulse emitted from the pulse generator 11 is supplied to the row address counter 10 to increment it by 1. By this means, a word line not requiring refreshing is not selected during the refresh period.

Thus in this embodiment, by setting at an appropriate value of CR time constant, refreshing of word line not selected during the refresh period because of previous access can be effected in the next refresh period before the data in the memory cells connected to those word lines becomes corrupted. The electric power consumption needed for one refresh operation can therefore be reduced, and the refresh period shortened.

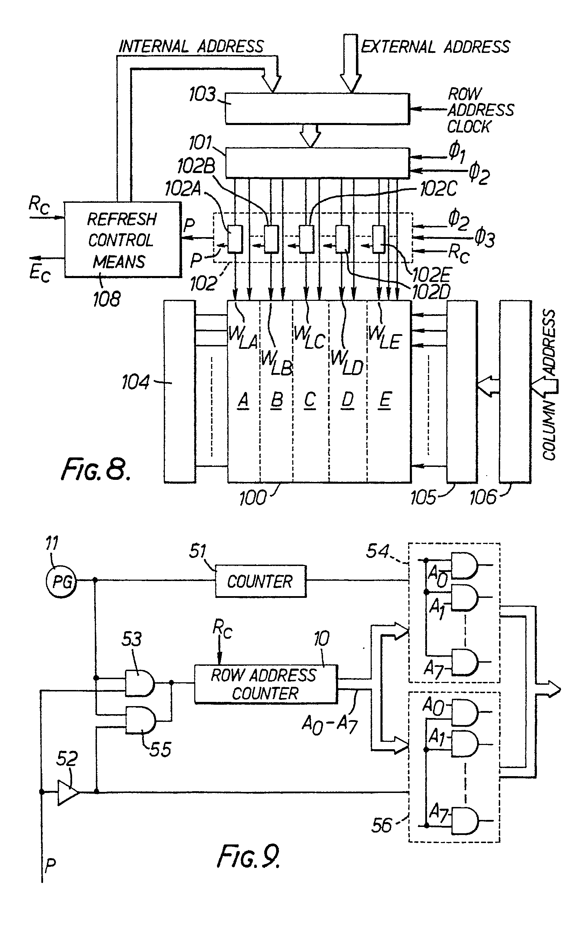

Figure 8 shows another embodiment of the present invention. In this embodiment the memory cells are divided into a plurality of blocks A-E, and the refresh is carried out from block to block. One block corresponds to fifty word lines, for example, and the time constant means $102_A$-$102_E$, the configuration of which is the same as that shown in Figure 6 are respectively connected only to the first word lines $WL_A$-$WL_E$ of each block. Conventional refresh circuits are connected to the remaining word lines. If the time constant means connected to the first word line $WL_A$ of the block A emits the signal P indicating the refresh is not required, all word lines in the block A are unconditionally skipped. If the time constant means connected to the first word line of the block A detects that the refresh is necessary, all word lines in the block A are sequentially selected and refreshing is carried out word line by word line.

Figure 9 is a circuit diagram showing the main parts of a refresh control means 108 to establish the above-mentioned operation. The refresh control means 108 consists of a row address counter 10, a pulse generator 11, a counter 51, NOT gate 52, AND gates 53 and 55 and AND gate circuits 54 and 56. The counter 51 emits a pulse in every fifty pulses from the pulse generator 11, and supplies the output signal to AND gate 54. Assuming now that the signal P emitted from the time constant means connected to the first word line $WL_A$ of block A is 'high', AND gate 53 opens, and then the row address counter 10 is incremented by the pulses from the pulse generator 11. When the row address counter 10 reaches a count of fifty, the counter 51 emits the output signal, and the output from the row address counter is then transferred to the row address buffer 103 through AND gate circuit 54. If the signal P is 'low' on the other hand, the signal P is converted to 'high' by NOT gate 52. The output signal of the NOT gate 52 is supplied to AND gates 55 and AND gate circuit 56. Therefore, the row address counter 10 is incremented by the pulses from the pulse generator 11, and each address corresponding to the address counter 10 is sequentially transferred to the row address buffer 103 through AND gate circuit 56.

As described above, according to the second embodiment of the present invention, the same effects as that described in the former embodiment can be obtained, when the dynamic memory is used especially for a data transfer apparatus or a static image treatment apparatus.

This invention is not restricted to the embodiments described above. For example, the time constant means referred to above need not be constituted by a resistor and a capacitor connected in parallel, but all that is necessary is that it should be activated by the selection of the word line in an access period, and that its output should alter in one direction or after a given period of time. Further, the refresh control means is not confined to the layout described above and illustrated by Figures 4 and 9, but may be varied as appropriate.

## Claims

1. A semiconductor memory device comprising a plurality of memory cells (100) each consisting of one transistor (1) and one capacitor (2), a plurality of word lines ($W_L$) for addressing said memory cells, a plurality of digit lines (Wd) for reading and/or writing the data of said memory cells, an access control means (101, 103) for accessing said memory cells by selecting said word lines, a refresh clock Rc for starting a refresh period at fixed intervals, a refresh control means (107) for successively selecting said word line connected to each of said memory cells and refreshing said memory cells word line by word line in the refresh period; characterised by

a pulse generator (11) generating pulses at intervals shorter than the time taken to refresh one word line, and a timing means (102) connected to each of the word lines, each of said timing means (102) being so arranged that it is activated whenever the word line connected to it is selected during an access period and being arranged to supply a "refresh not required" signal until a predetermined time has elapsed, said refresh control means (107) being arranged to detect said "refresh not required" signal and to then select the next word line, and wherein said refresh control means (107) includes;

a row address counter (10) for successively selecting said word lines in accordance with pulse signals from said pulse generator, a first circuit means (12) for detecting the data in said row address counter and emitting a pulse signal indicating the end of said refresh period, and a second circuit means (15) which is so arranged that

(a) when said "refresh not required" signal is supplied from said timing means, the row address counter is incremented by 1 without a refresh signal being issued to the corresponding word line; and

(b) when said "refresh not required" signal is not supplied, the incrementation of the row address counter is delayed, a refresh signal is issued, and the row address counter is incremented after completion of the refresh process for the corresponding word line.

2. A semiconductor memory device according to claim 1, wherein said timing means (102) includes:;

a capacitor (32) arranged to be charged on selection of said word line,

a resistor (31) connected in parallel to said capacitor so as to discharge said capacitor with a time constant CR, where R is the resistance of said resistor and C is the capacitance of said capacitor.

3. A semiconductor memory device according to claim 2, wherein said time constant CR is variable.

4. A semiconductor memory device according to any preceding claim, wherein said transistor (1) is a MOS transistor whose gate is connected to said word line and whose drain is connected to said digit line.

5. A semiconductor memory device according to any preceding claim, wherein said capacitor (2) is a MOS capacitor which stores the data for storage in the form of an electric charge.

6. A semiconductor memory device according to any preceding claim, wherein said plurality of memory cells comprise a random access memory.

7. A semiconductor memory device according to any preceding claim in which said memory cells (100) are divided into a plurality of blocks (A-E), the first word lines (WL$_A$-WL$_E$) of each of the blocks being connected to respective timing means (102) which are activated whenever said first word line connected to it is selected during an access period and emitting a "refresh not required" signal until a predetermined time has elapsed, whereby said refresh control means (107) selects in said refresh period all of the word lines in the first block whose word line is connected to a timing means which does not emit said "refresh not required" signal.

8. A semiconductor memory device according to claim 7, wherein said refresh control means (107) includes a circuit (10, 51, 54) for supplying row address signals corresponding to the first word line of each of said blocks when said time constant means emits said "refresh not required" signal.

**Revendications**

1. Dispositif de mémoire semi-conductrice qui comprnd un certain nombre de cellules de mémoire (100) dont chacune se compose d'un transistor (1) et d'un condensateur (2), un certain nombre de lignes de circulation de mots (W$_L$) aux fins d'adressage desdites cellules de mémoire, un certain nombre de lignes de circulation de chiffres (Wd) pour lire et/ou écrire les données desdites cellules de mémoire, des moyens de commande d'accès (101, 103) pour accéder auxdites cellules de mémoire par sélection desdites lignes de circulation de mots, une horloge de rafraîchissement Rc pour démarrer une période de rafraîchissement à des intervalles fixes, des moyens de commande de rafraîchissement (107) pour sélectionner successivement la ligne de circulation de mots connectée à achacune desdites cellules de mémoire et pour rafraîchir la ligne de circulation de mots connectés à chacune desdites cellules de mémoire et rafraîchir la ligne de circulation de mots desdites cellules de mémoire par la ligne de circulation de mots au cours de la période de rafraîchissement, caractérisé par un générateur d'impulsions (11) qui engendre des impulsions à ces intervalles plus courts que le temps nécessaire pour rafraîchir une ligne de circulation de mots, et des moyens de chronométrie (102) connectés à chacune des lignes de circulation de mots, chacun desdits moyens de chronométrie (102) étant conçu de telle manière qu'il est activé chaque fois qu'une ligne de circulation de mots à lui connectée

est sélectionnée durant une période d'accès et étant arrangée pour délivrer un signal de "non-nécessité de rafraîchissement" jusqu'à ce qu'une période de temps prédéterminée se soit écoulée, lesdits moyens de commande de rafraîchissement (107) étant conçus pour détecter ledit signal de "non-nécessité de rafraîchissement" et pour ensuite sélectionner la ligne de circulation de mots suivante, et dans lequel lesdits moyens de commande de rafraîchissement (107) comprennent :

un compteur d'adresse de rangée (10) pour sélectionner successivement lesdites lignes de circulation de mots en fonction des signaux pulsés provenant dudit générateur d'impulsions, un premier circuit (12) pour détecter les données présentes dans ledit compteur d'adresse et pour délivrer un signal pulsé indiquant la fin de ladite période de rafraîchissement, et un second circuit qui est conçu de façon que :

(a) quand lesdits moyens de chronométrie délivrent ledit signal de "non-nécessité de rafraîchissement", le contenu du compteur d'adresse de rangée est incrémenté de 1 sans qu'un signal de rafraîchissement soit délivré à la ligne de circulation de mots correspondante; et

(b) quand ledit signal de "non-nécessité de rafraîchissement" n'est pas délivré, l'incrémentation du compteur de rangée d'adresse est différée, un signal de rafraîchissement est émis et le compteur de rangée d'adresse est incrémenté à l'achèvement du processus de rafraîchissement de la ligne de circulation de mots correspondante.

2. Dispositif de mémoire semi-conductrice selon la revendication 1, caractérisé en ce que les moyens de chronométrie (102) comprennent un condensateur (32) monté de façon à être chargé à la sélection de ladite ligne de circulation de mots, et une résistance (31) branchée en parallèle sur ledit condensateur afin de décharger ce dernier avec une certaine constante de temps CR, où R désigne la valeur ohmique de ladite résistance et C désigne la capacité dudit condensateur.

3. Dispositif de mémoire semi-conductrice, selon la revendication 2, caractérisé en ce que ladite constante de temps CR est variable.

4. Dispositif de mémoire semi-conductrice, selon l'une quelconque des revendications précédentes, caractérisé en ce que ledit transistor (1) est un transistor MOS dont la porte est connectée à ladite ligne de circulation de mots, tandis que son drain est relié à la ligne numérique.

5. Dispositif de mémoire semi-conductrice, selon l'une quelconque des revendications précédentes, caractérisé en ce que ledit condensateur (2) est un condensateur MOS qui conserve les données sous la forme d'une charge électrique.

6. Dispositif de mémoire semi-conductrice, selon l'une quelconque des revendications précédentes, caractérisé en ce que ladite multiplicité de cellules de mémoire comprend une mémoire à accès aléatoire.

7. Dispositif de mémoire semi-conductrice, selon l'une quelconque des revendications précédentes, caractérisé en ce que lesdites cellules de mémoire (106) sont divisées en un certain nombre de blocs (A-E). Les premières lignes de circulation de mots ($WL_A$-$WL_E$) de chaque bloc étant connectées à leurs moyens de temporisation respectifs (102) lesquels sont activés chaque fois que la ligne de circulation de mots qui y est connectée est sélectionnée durant une période d'accès et émet un signal de "rafraîchissement pas nécessaire" jusqu'à ce qu'une période de temps prédéterminée s'est écoulée, ce qui fait que lesdits moyens de commande de rafraîchissement (107) sélectionnent, dans ladite période de rafraîchissement, toutes les lignes de circulation de mots du premier bloc dont la ligne de circulation de mots est connectée à un moyen de temporisation qui n'émet pas de signal "rafraîchissement pas nécessaire".

8. Dispositif de mémoire semi-conductrice, selon la revendication 7, caractérisé en ce que les moyens de commande de rafraîchissement (107) comportent un circuit (10, 51, 54) pour fournir les signaux d'adresse de rangée correspondant à la première ligne de circulation de mots de chacun desdits blocs quand lesdits moyens à constante de temps émettent ledit signal de "rafraîchissement pas nécessaire".

## Patentansprüche

1. Halbleiterspeicheranordnung mit einer Vielzahl von Speicherzellen (100), die jeweils aus einem Transistor (1) und einem Kondensator (2) bestehen, einer Vielzahl von Wortleitungen ($W_L$) zum Adressieren der Speicherzellen, einer Vielzahl von Datenleitungen (Wd) zum Lesen und/oder Schreiben der Daten der Speicherzellen, einer Zugriffssteuerungseinrichtung (101, 103) zum Zugreifen auf die Speicherzellen durch Auswahl der Wortleitungen, einer Auffrischungsuhr ($R_c$) zum Starten einer Auffrischungsperiode in festgelegten Abständen, einer Auffrischungssteuerungseinrichtung (107) zur sukzessiven Auswahl der mit jeder der Speicherzellen verbundenen Wortleitungen und zum Auffrischen der Speicherzellen Wortleitung für wortleitung in der Auffrischungsperiode,
gekennzeichnet durch

einen Pulsgenerator (11), der Pulse in Abständen erzeugt, die kürzer als die Zeit zum Auffrischen einer Wortleitung sind, und Zeitgebereinrichtungen (102), die mit jeder der Wortleitungen verbunden sind, wobei jede der Zeitgebereinrichtungen (102) so ausgelegt ist, daß sie immer aktiviert wird, wenn die mit ihr verbundene Wortleitung während einer Zugriffsperiode ausgewählt wird, und dazu ausgelegt ist, ein "Auffrischung nicht erforderlich"-Signal auszugeben, bis eine vorgegebene Zeitspanne vergangen ist, wobei die Zugriffssteuerungseinrichtung (107) so ausgelegt ist, daß sie das "Auffrischung nicht erforderlich"-Signal nachweist und daraufhin die nächste Wortleitung auswählt, und wobei die Auffrischungssteuerungseinrichtung (107) aufweist:

einen Zeilenadressenzähler (10) zur sukzessiven Auswahl der wortleitungen gemäß der Pulse von dem Pulsgenerator, eine erste Schaltungseinrichtung (12) zum Nachweisen der Daten in dem Zeilenadressenzähler und zum Aussenden eines Pulssignals, das das Ende der Auffrischungsperiode anzeigt, und eine zweite Schaltungseinrichtung (15), die so ausgelegt ist, daß
(a) bei vorliegen eines "Auffrischung nicht erforderlich" - Signals von der Zeitgebereinrichtung der Zeilenadressenzähler um 1 erhöht wird, ohne daß ein Auffrischungssignal auf die entsprechende Wortleitung gegeben wird, und
(b) bei Nichtvorliegen eines "Auffrischung nicht erforderlich" -Signals das Heraufzählen des Zeilenadressenzählers verzögert wird, das Auffrischungssignal ausgegeben und, nachdem der Auffrischungsvorgang für die entsprechende Wortleitung abgeschlossen ist, der Zeilenadressenzähler heraufgezählt wird.

2. Halbleiterspeicheranordnung nach Anspruch 1, wobei die Zeitgebereinrichtung (102) aufweist:

Einen Kondensator (32), der eingerichtet ist, bei Auswahl der Wortleitung aufgeladen zu werden,

einen Widerstand (31), der parallel zu dem Kondensator geschaltet ist, um den Kondensator mit einer Zeitkonstanten CR zu entladen, wobei R der Widerstandswert des Widerstandes und C die Kapazität des Kondensators ist.

3. Halbleiterspeicheranordnung nach Anspruch 2, wobei die Zeitkonstante CR variabel ist.

4. Halbleiterspeicheranordnung nach einem der vorhergehenden Ansprüche, wobei der Transistor (1) ein MOS-Transistor ist, dessen Gate mit der Wortleitung und dessen Drain mit der Datenleitung verbunden ist.

5. Halbleiterspeicheranordnung nach einem der vorhergehenden Ansprüche, wobei der Kondensator (2) ein MOS-Kondensator ist, der die zu speichernden Daten in Form von elektrischer Ladung speichert.

6. Halbleiterspeicheranordnung nach einem der vorhergehenden Ansprüche, wobei die Vielzahl von Speicherzellen eine Speicheranordnung mit wahlfreiem Zugriff umfaßt.

7. Halbleiterspeicheranordnung nach einem der vorhergehenden Ansprüche, bei der die Speicherzellen (100) in eine Vielzahl von Blöcken (A-E) eingeteilt sind, die ersten Wortleitungen ($WL_A$-$WL_E$) jedes Blocks mit der zugehörigen Zeitgebereinrichtung (102) verbunden sind, die immer aktiviert wird, wenn die mit ihr verbundene erste Wortleitung während einer Zugriffsperiode ausgewählt wird, und ein "Auffrischung nicht erforderlich"-Signal aussendet, bis eine vorgegebene Zeitspanne vergangen ist, wodurch die Auffrischungssteuerungseinrichtung (107) in der Auffrischungsperiode alle Wortleitungen in dem ersten Block auswählt, deren Wortleitung mit einer Zeitgebereinrichtung verbunden ist, die kein "Auffrischung nicht erforderlich"-Signal aussendet.

8. Halbleiterspeicheranordnung nach Anspruch 7, wobei die Auffrischungssteuerungseinrichtung (107) eine Schaltung (10, 51, 54) aufweist zum Ausgeben von der ersten Wortleitung jedes Blocks entsprechenden Zeilenadressensignalen, wenn die Zeitgebereinrichtung das "Auffrischung nicht erforderlich"-Signal aussendet.

FIG. 1.

FIG. 2.

FIG.3.

FIG.4.

FIG.5.

EP 0 116 774 B1

Fig.6.

13

FiG.7.

EP 0 116 774 B1

FIG. 8.

FIG. 9.